# EUROPEAN PATENT APPLICATION

(11) **EP 2 147 987 A1**
(43) Date of publication of application: **27.01.2010**
(21) Application number: 09008908.7
(22) Date of filing: 08.07.2009
(51) Int. Cl.: C23C 16/455

(54) **Vapor growth apparatus, vapor growth method, and method for manufacturing semiconductor device**

(30) Priority: 18.07.2008 JP 2008187778
(71) Applicant: Kabushiki Kaisha Toshiba, Minato-ku, Tokyo 105-8001 (JP)
(72) Inventor: Kohji, Yoshiharu, Tokyo (JP); Ishikawa, Hironori, Tokyo (JP)
(74) Representative: HOFFMANN EITLE

(57) **Abstract**

A vapor growth apparatus forming a film on a substrate using a first source gas and a second source gas different form the first source gas, includes: a reaction chamber in which the substrate is disposed; a first source gas introduction path that communicates with the reaction chamber and introduces the first source gas; a second source gas introduction path that communicates with the reaction chamber and introduces the second source gas; and a separation gas introduction path that communicates with the reaction chamber between the first source gas introduction path and the second source gas introduction path and introduces a separation gas. The separation gas has a reaction rate with the first source gas and a reaction rate with the second source gas lower than the reaction rate between the first source gas and the second source gas.

## Description

### CROSS-REFERENCE TO RELATED APPLICATIONS

This application is based upon and claims the benefit of priority from the prior Japanese Patent Application No.2008-187778, filed on July 18, 2008; the entire contents of which are incorporated herein by reference.

### BACKGROUND OF THE INVENTION

### Field of the Invention

The present invention relates to a vapor growth apparatus, a vapor growth method, and a method for manufacturing a semiconductor device.

### Background Art

During the manufacture of semiconductor devices, vapor growth apparatuses form films using various different source gases. For example, in an MOCVD (Metal Organic Chemical Vapor Deposition) apparatus during the manufacture of an HEMT (High Electron Mobility Transistor) having an AlGaN/GaN heterointerface, for example, a group 5 gas and a group 3 gas are introduced into a reaction chamber with a carrier gas. The gases are heated, decomposed, and precipitated as an epitaxial crystal on a substrate to form a film. At such a time, the gases introduced into the reaction chamber are heated by radiant heat and the like from the heated substrate. Thereby, crystal growth reactions occur at locations other than on the substrate, e.g., on inner walls of the reaction chamber, gas introduction paths, etc. As a result, the source gas is consumed at locations other than on the substrate where the film is to be formed, and the consumption efficiency of source materials decreases. Further, such results cause negative effects on apparatus life, and impede the stability of manufacturing conditions.

Technology is disclosed in JP-A 2003-51457 (Kokai) in which multiple source gases are guided to a proximity of the substrate in a separated state by a baffle member and blown onto the substrate. However, during film formation of GaN, for example, it is necessary to heat the substrate to a temperature of about 1,000 °C. The heat resistance of the material of the baffle member cannot withstand such a temperature. Therefore, it is difficult to provide the baffle member proximal to the substrate, and practical use of such technology is difficult.

### SUMMARY OF THE INVENTION

According to an aspect of the invention, there is provided a vapor growth apparatus forming a film on a substrate using a first source gas and a second source gas different from the first source gas, the apparatus comprising: a reaction chamber, the substrate being disposed in the reaction chamber; a first source gas introduction path communicating with the reaction chamber and introducing the first source gas; a second source gas introduction path communicating with the reaction chamber and introducing the second source gas; and a separation gas introduction path communicating with the reaction chamber between the first source gas introduction path and the second source gas introduction path and introducing a separation gas, the separation gas having a reaction rate with the first source gas lower than a reaction rate between the first source gas and the second source gas, and the separation gas having a reaction rate with the second source gas lower than the reaction rate between the first source gas and the second source gas.

According to another aspect of the invention, there is provided a vapor growth method forming a film on a substrate using a plurality of source gases, the method performing vapor growth by introducing a first source gas and a second source gas onto the substrate while separating the first source gas and the second source gas from each other by a separation gas having a reaction rate with the first source gas lower than a reaction rate between the first source gas and the second source gas and a reaction rate with the second source gas lower than the reaction rate between the first source gas and the second source gas.

According to another aspect of the invention, there is provided a method for manufacturing a semiconductor device, the device including a semiconductor layer vapor-deposited on a substrate and an electrode connected to the semiconductor layer, the method comprising introducing a first source gas being a source material of the semiconductor layer, and a second source gas being a source material of the semiconductor layer, onto the substrate to perform vapor growth of the semiconductor layer while separating the first and the second source gases from each other by a separation gas having a reaction rate with the first source gas lower than a reaction rate between the first source gas and the second source gas and a reaction rate with the second source gas lower than the reaction rate between the first source gas and the second source gas.

### BRIEF DESCRIPTION OF THE DRAWINGS

FIG. 1 is a schematic view illustrating the configuration of a vapor growth apparatus according to a first embodiment of the invention;
FIG. 2 is a schematic view illustrating the configuration of a vapor growth apparatus of a comparative example;
FIG. 3 is a schematic view illustrating the configuration of a vapor growth apparatus according to a second embodiment of the invention;
FIG. 4 is a schematic view illustrating the configuration of a vapor growth apparatus according to a third embodiment of the invention;
FIG. 5 is a schematic cross-sectional view illustrating the configuration of the main components of the vapor growth apparatus according to the third embodiment of the invention;
FIG. 6 is a cross-sectional view along line A-A' of FIG. 5;
FIG. 7 is a schematic view illustrating characteristics of the vapor growth apparatus according to the third embodiment of the invention;
FIG. 8 is a flowchart illustrating a vapor growth method according to a fourth embodiment of the invention;
FIGS. 9A and 9B are schematic views illustrating the structure of a semiconductor device manufactured by the vapor growth apparatus and the vapor growth method according to an embodiment of the invention;
FIG. 10 is a schematic view illustrating the structure of another semiconductor device manufactured by the vapor growth apparatus and the vapor growth method according to an embodiment of the invention; and
FIG. 11 is a schematic view illustrating the structure of another semiconductor device manufactured by the vapor growth apparatus and the vapor growth method according to an embodiment of the invention.

### DETAILED DESCRIPTION OF THE INVENTION

### Description of the Preferred Embodiments

Embodiments of the invention will now be described in detail with reference to the drawings.

In this specification and the drawings, components similar to those described in regard to a drawing thereinabove are marked with like reference numerals, and a detailed description is omitted as appropriate.

### First embodiment

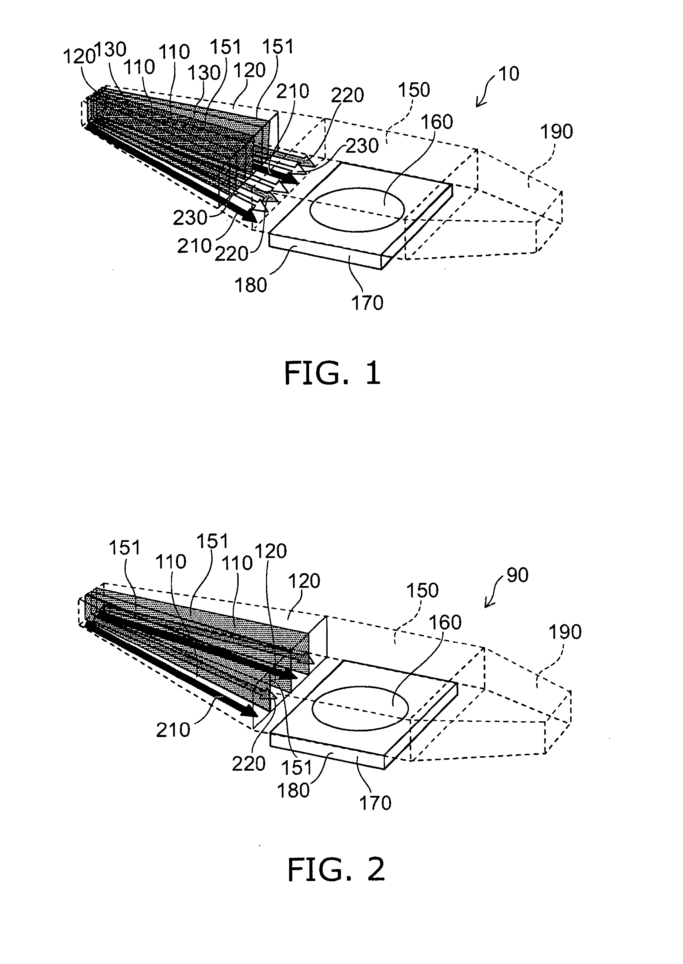

FIG. 1 is a schematic view illustrating the configuration of a vapor growth apparatus according to a first embodiment of the invention. A vapor growth apparatus 10 according to the first embodiment of the invention illustrated in FIG. 1 forms a film on a substrate 160 using multiple source gases, that is, a first source gas 210 and a second source gas 220 which is different from the first source gas 210.

The vapor growth apparatus 10 includes: a reaction chamber 150 in which the substrate 160 is disposed; a first source gas introduction path 110 that communicates with the reaction chamber 150 and introduces the first source gas 210; a second source gas introduction path 120 that communicates with the reaction chamber 150 and introduces the second source gas 220; and a separation gas introduction path 130 provided between the first and second source gas introduction paths 110 and 120 to introduce a separation gas 230 which has a slow reaction rate with the first and second source gases 210 and 220.

The vapor growth apparatus 10 of this specific example is a horizontal-flow MOCVD apparatus. The reaction chamber 150 includes a substrate holder 170, provided in an interior of the reaction chamber 150, on which the substrate 160 is placed. The first and second source gas introduction paths 110 and 120 and the separation gas introduction path 130 are provided at a side of the substrate holder 170. However, as described below, the vapor growth apparatus also may have a vertical structure.

A heater 180 may be provided in the substrate holder 170. The heater 180 heats the substrate 160 to cause the source gases recited above to react and form a film.

An exhaust portion 190 is provided on the reaction chamber 150 to exhaust gases that have finished reacting.

In this specific example, the first source gas introduction path 110, the second source gas introduction path 120, and the separation gas introduction path 130 communicate with an inner wall of the reaction chamber 150, and are mutually separated by baffle members 151 formed a sufficient distance from the substrate holder 170. Then, the first source gas 210, the second source gas 220, and the separation gas 230 are introduced in a substrate holder 170 direction at a side of the baffle members 151 toward the substrate holder 170 in a mutually separated state without baffle members 151 therebetween.

Thus, in the vapor growth apparatus 10 according to this embodiment, the baffle member 151 can be formed at a distance from the substrate holder 170 sufficient to withstand the substrate temperature during film formation. Then, the first source gas 210 and the second source gas 220 are introduced to the substrate surface at the side of the baffle members 151 toward the substrate holder 170 in a state of being essentially separated by the separation gas 230 introduced from the separation gas introduction path 130.

The first source gas 210 may include, for example, at least one selected from the group consisting of trimethyl gallium (TMG), trimethyl indium (TMI), triethyl gallium (TEG), triethyl aluminum (TEA), TEI (triethyl indium), a hydride of Si, and a hydride of carbon. These gases may be mixtures including various carrier gases.

The second source gas 220 may include, for example, at least one selected from the group consisting of NH₃, AsH₃, PH₃, and SbH₃. These gases may be mixtures including various carrier gases.

However, the invention is not limited thereto. The gas used for the first source gas 210 recited above and the gas used for the second source gas 220 recited above may be mutually interchanged. Also, any appropriate gas other than the gases recited above may be used for each of the first and second source gases 210 and 220. In other words, it is sufficient that the first source gas 210 and the second source gas 220 are mutually different gases. Then, as described below, the effects of this embodiment can be provided by separating these gases by the separation gas in the case where the first source gas 210 and the second source gas 220 are mutually reactive gases.

The first and second source gases 210 and 220 may include various doping gases.

The separation gas 230 may include N₂, H₂, a noble gas, and the like. Noble gases are helium, neon, argon, krypton, xenon, and radon. However, the invention is not limited thereto; and the separation gas 230 may include various gases having slow reaction rates with the first and second source gases 210 and 220. For example, the separation gas 230 may be a gas that essentially does not react with the first and second source gases 210 and 220.

The separation gas introduction path 130 of the vapor growth apparatus 10 that introduces the separation gas 230 is provided between the first source gas introduction path 110 and the second source gas introduction path 120. The first and second source gases 210 and 220 are introduced to the surface of the substrate 160 in a state of being mutually separated by the separation gas 230.

Thereby, a vapor growth apparatus using multiple source gases can be provided to inhibit mutual mixing of the first and second source gases 210 and 220 in a location other than on the substrate 160 and inhibit reactions outside of the target location, that is, the surface of the substrate 160.

### Comparative example

FIG. 2 is a schematic view illustrating the configuration of a vapor growth apparatus of a comparative example.

As illustrated in FIG. 2, a vapor growth apparatus 90 of the comparative example also is a vapor growth apparatus that forms a film on a substrate using multiple source gases, that is, the first source gas 210 and the second source gas 220 which is different from the first source gas 210.

The baffle members 151 are provided in the vapor growth apparatus 90 of the comparative example to separate the first and second source gases and introduce the first and second source gases to a proximity of the substrate. In other words, the first and second source gases 210 and 220 pass through the first and second source gas introduction paths 110 and 120, respectively, and are blown onto the substrate 160 in a state of being separated by the baffle member 151 linked to the first and second source gas introduction paths 110 and 120. The first and second source gases 210 and 220 can be inhibited thereby from mutually mixing at a location other than the surface of the substrate 160.

In this case, it is necessary to extend the baffle member 151 to be as proximal as possible to the substrate 160 to inhibit the mutual mixing of the first and second source gases 210 and 220 at a location other than the surface of the substrate 160. In other words, the baffle member 151 is proximal to the substrate holder 170 on which the substrate 160 is disposed and is proximal also to the heater 180. The substrate temperature during film formation of, for example, GaN, is about 1,000 °C. Heating the substrate 160 to such a high temperature exposes the baffle member 151 to a high temperature due to the radiant heat from the substrate 160 and the heat from the heater 180. The material used for the baffle member 151 must withstand such high temperatures, and is limited to expensive materials such as quartz. Because it is necessary to fashion such a material into a prescribed configuration to form the baffle member 151, the material is limited further to satisfactorily allow workability and heat resistance; and is impractical.

Conversely, in the vapor growth apparatus 10 according to this embodiment as described above, the first and second source gases 210 and 220 are separated by the separation gas 230. Therefore, problems such as those described above occurring due to the baffle member 151 do not occur. Then, the first and second source gases 210 and 220 can be introduced onto the substrate 160 in an essentially separated state.

Thereby, a vapor growth apparatus using multiple source gases can be provided to inhibit mutual mixing of the first and second source gases 210 and 220 in a location other than on the substrate 160 and inhibit reactions outside of the target location, that is, the surface of the substrate 160. Thereby, the consumption efficiency of source materials can be improved, negative effects on apparatus life can be avoided, and the stability of manufacturing conditions can be improved.

Multiple first source gas introduction paths 110 and multiple second source gas introduction paths 120 are provided in the vapor growth apparatus 10 according to this embodiment illustrated in FIG. 1. Each of the first source gas introduction paths 110 is provided between each of the second source gas introduction paths 120; and the separation gas introduction path 130 is provided between the first source gas introduction path 110 and the second source gas introduction path 120.

In other words, a plurality of the first source gas introduction paths 110 and a plurality of the second source gas introduction paths 120 are provided in the vapor growth apparatus 10; the second source gas introduction path 120 is provided between at least two first source gas introduction paths 110; and the separation gas introduction path 130 is provided between each of the first source gas introduction paths 110 and the second source gas introduction path 120.

Thereby, the first source gas 210 and the second source gas 220 can be alternately introduced while being separated, and can be introduced to the surface of the substrate 160 in a state of high uniformity. A highly uniform film is thereby possible.

Although two of the first source gas introduction paths 110, two of the second source gas introduction paths 120, and two of the separation gas introduction paths 130 are provided in the vapor growth apparatus 10 illustrated in FIG. 1, more first and second source gas introduction paths 110 and 120 and separation gas introduction paths 130 may be provided. In such a case, the numbers of the first and second source gas introduction paths 110 and 120 may be different; and it is sufficient that the separation gas introduction path 130 is provided between each of the first and second source gas introduction paths 110 and 120.

In the vapor growth apparatus 10 according to this embodiment illustrated in FIG. 1, the first source gas introduction path 110, the second source gas introduction path 120, and the separation gas introduction path 130 include a portion being mutually separated by the baffle members 151. In another portion between the baffle members 151 and the substrate holder 170, the baffle members 151 are not used for separation; and the first source gas introduction path 110 and the second gas introduction path 120 are separated by the separation gas 230 introduced by the separation gas introduction path 130. Restated, the first gas introduction path 110, the second gas introduction path 120, and the separation gas introduction path 130 include a portion between the baffle members 151 and the substrate holder 170 being integrally formed without separation by the baffle members 151.

In other words, the vapor growth apparatus 10 according to this embodiment is a vapor growth apparatus forming a film on a substrate 160 using a first source gas 210 and a second source gas 220 which is different from the first source gas 210, including: a reaction chamber 150 in which the substrate 160 is disposed; a first source gas introduction path 110 that communicates with the reaction chamber 150 and introduces the first source gas 210; a second source gas introduction path 120 that communicates with the reaction chamber 150 and introduces the second source gas 220; and a separation gas introduction path 130 that communicates with the reaction chamber 150 between the first source gas introduction path 110 and the second source gas introduction path 120 and introduces a separation gas 230 having a reaction rate with the first source gas 210 lower than a reaction rate between the first source gas 210 and the second source gas 220 and having a reaction rate with the second source gas 220 lower than a reaction rate between the first source gas 210 and the second source gas 220; the first source gas introduction path 110, the second source gas introduction path 120, and the separation gas introduction path 130 including a portion being mutually separated by the baffle member 151 and a portion being integrally formed without separation by the baffle member 151.

Thus, in the vapor growth apparatus 10 according to this embodiment, each of the introduction paths includes a portion not separated by the baffle member 151. Therefore, a vapor growth apparatus using multiple source gases can be provided that can dispose the baffle member 151 at a sufficient distance from the substrate holder 170 to avoid problems due to the heat resistance of the baffle member 151, inhibit mutual mixing of the first and second source gases 210 and 220, and inhibit reactions outside of the target location, that is, the surface of the substrate 160.

### Second embodiment

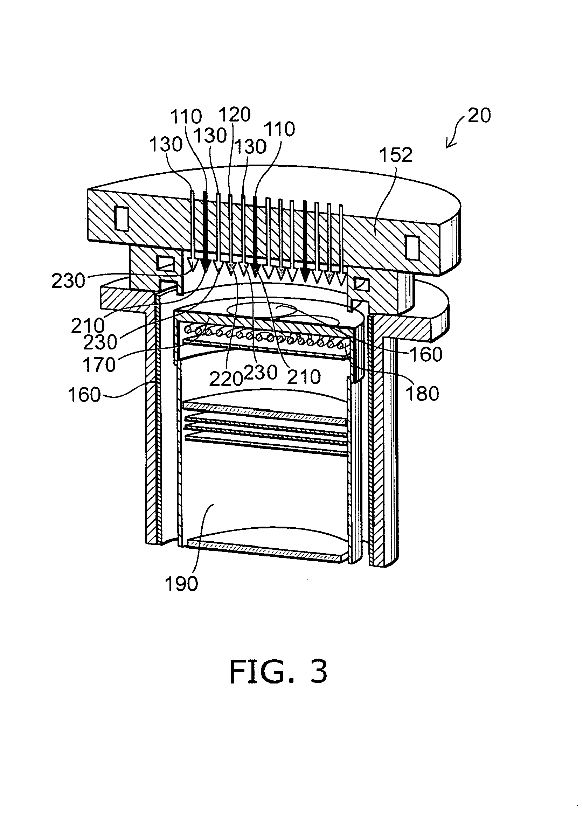

FIG. 3 is a schematic view illustrating the configuration of a vapor growth apparatus according to a second embodiment of the invention. Namely, FIG. 3 is a schematic perspective view of the vapor growth apparatus cut along a plane perpendicular to a major surface of the substrate holder.

A vapor growth apparatus 20 according to the second embodiment of the invention illustrated in FIG. 3 forms a film on the substrate 160 using multiple source gases, that is, the first source gas 210 and the second source gas 220 which is different from the first source gas 210. In this specific example, the vapor growth apparatus 20 is a vertical MOCVD vapor growth apparatus.

In other words, in the vapor growth apparatus 20 according to this embodiment, the reaction chamber 150 includes the substrate holder 170 provided in an interior of the reaction chamber 150 on which the substrate 160 is placed. The first and second source gas introduction paths 110 and 120 and the separation gas introduction path 130 are provided above the substrate holder 170.

In such a case, the exhaust portion 190 is provided below the substrate holder 170.

The heater 180 may be provided in the substrate holder 170. The heater 180 heats the substrate 160 to cause the source gases recited above to react and form a film.

Similar to that of the first embodiment, the vapor growth apparatus 20 includes: the reaction chamber 150 in which the substrate 160 is disposed; the first source gas introduction path 110 that communicates with the reaction chamber 150 and introduces the first source gas 210; the second source gas introduction path 120 that communicates with the reaction chamber 150 and introduces the second source gas 220; and the separation gas introduction path 130 provided between the first and second source gas introduction paths 110 and 120 to introduce a separation gas 230 which has a slow reaction rate with the first and second source gases 210 and 220.

The various materials described in the first embodiment also may be used as the first and second source gases 210 and 220 and the separation gas 230 of the vapor growth apparatus 20 according to this embodiment.

In the vapor growth apparatus 20, the separation gas introduction path 130 which introduces the separation gas 230 is provided between the first source gas introduction path 110 and the second source gas introduction path 120. The first and second source gas introduction paths 210 and 220 are introduced to the surface of the substrate 160 in a state of being mutually separated by the separation gas 230.

Thereby, a vapor growth apparatus using multiple source gases can be provided to inhibit mutual mixing of the first and second source gases 210 and 220 in a location other than on the substrate 160 and inhibit reactions outside of the target location, that is, the surface of the substrate 160.

A plurality of the first source gas introduction paths 110 and a plurality of the second source gas introduction paths 120 are provided also in the vapor growth apparatus 20. Each of the first source gas introduction paths 110 is provided between each of the second source gas introduction paths 120; and the separation gas introduction path 130 is provided between the first source gas introduction path 110 and the second source gas introduction path 120 to improve the uniformity of the film formation.

In the vapor growth apparatus 20 according to this embodiment, the proportion of the cross-sectional area perpendicular to the gas introduction direction (for example, the proportion of inner diameters may be used in the case where the cross sections of the introduction paths are circular pipes) and the lengths thereof may be set arbitrarily to match the desired film formation conditions, and may be appropriately modified.

### Third embodiment

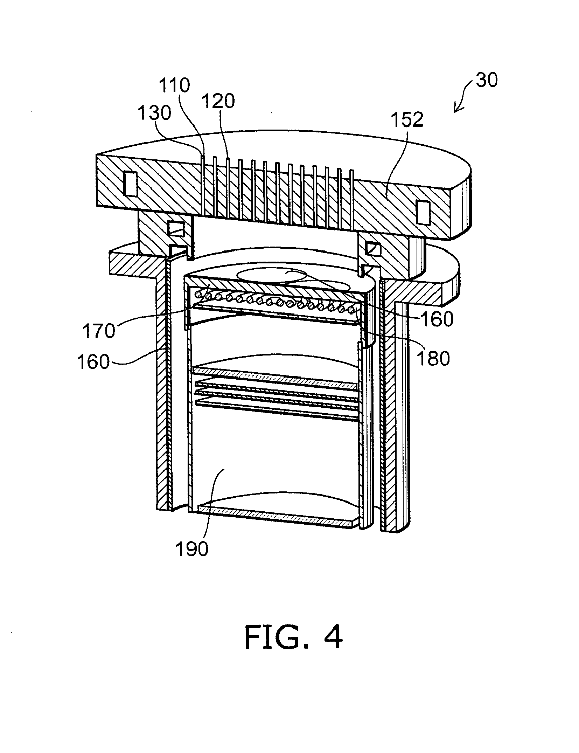

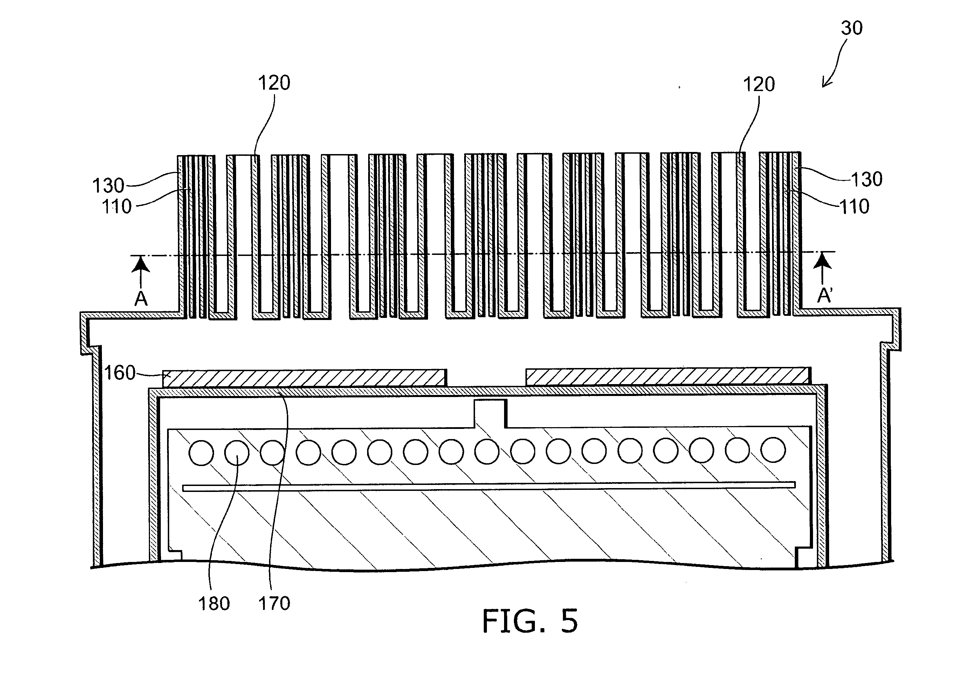

FIG. 4 is a schematic view illustrating the configuration of a vapor growth apparatus according to a third embodiment of the invention. FIG. 5 is a schematic cross-sectional view illustrating the configuration of the main components of the vapor growth apparatus according to the third embodiment of the invention.

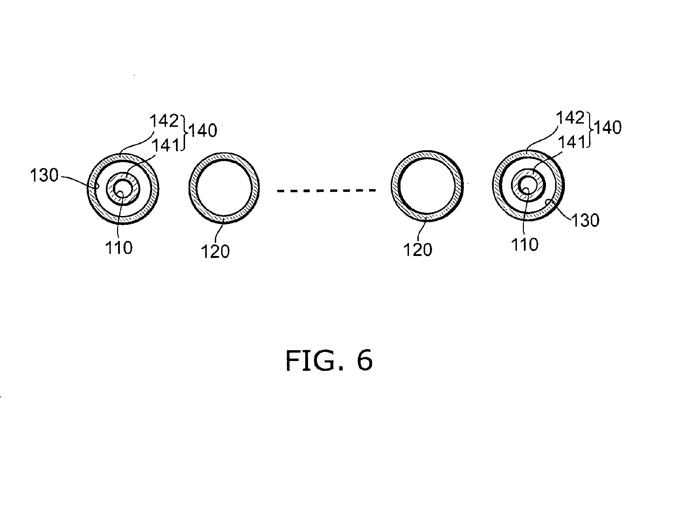

FIG. 6 is a cross-sectional view along line A-A' of FIG. 5.

Namely, FIG. 4 is a schematic perspective view of the vapor growth apparatus cut along a plane perpendicular to the major surface of the substrate holder. FIG. 5 is a schematic cross-sectional view illustrating an enlarged portion of the substrate holder and gas introduction portions of the vapor growth apparatus. An upper lid portion 152 in which the gas introduction paths are provided is omitted in FIG. 5 and FIG. 6.

A vapor growth apparatus 30 according to the third embodiment of the invention illustrated in FIG. 4 also is a vertical MOCVD apparatus that forms a film on the substrate 160 using multiple source gases, that is, the first source gas 210 and the second source gas 220 which is different from the first source gas 210.

In other words, in the vapor growth apparatus 30 according to this embodiment as well, the reaction chamber 150 includes the substrate holder 170 provided in an interior of the reaction chamber 150 on which the substrate 160 is placed. The first and second source gas introduction paths 110 and 120 and the separation gas introduction paths 130 are provided above the substrate holder 170.

In this case as well, the exhaust portion 190 is provided below the substrate holder 170.

The heater 180 may be provided in the substrate holder 170. The heater 180 heats the substrate 160 to cause the source gases recited above to react and form a film.

In the vapor growth apparatus 30 according to this embodiment illustrated in FIG. 5 and FIG. 6, the first source gas introduction path 110 and the separation gas introduction path 130 have a double pipe structure. Restated, the first source gas introduction path 110 is an inside pipe 141 of a double pipe structural unit 140; and the separation gas introduction path 130 is an outside pipe 142 of the double pipe structural unit 140.

On the other hand, the second source gas introduction path 120 has a simple pipe structure.

Thus, the first source gas 210 and the second source gas 220 can be mutually separated and introduced to the surface of the substrate 160 by using the inside pipe 141 of the double pipe structural unit 140 as the first source gas introduction path 110 and the outside pipe 142 thereof as the separation gas introduction path 130. In other words, the separation gas 230 can surround the first source gas 210 while being introduced to form a film.

Thus, the first source gas introduction path 110 and the second source gas introduction path 120 can be provided at a fine pitch by using the double pipe structure, and the uniformity of the film formation can be improved.

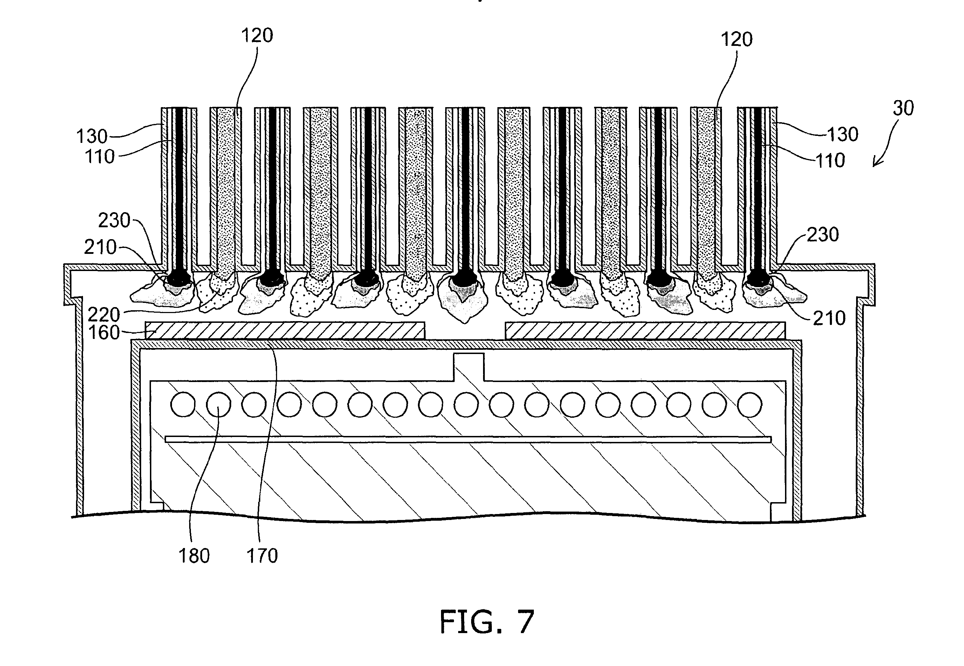

FIG. 7 is a schematic view illustrating characteristics of the vapor growth apparatus according to the third embodiment of the invention.

Namely, FIG. 7 illustrates results of a simulation of source gas concentrations in the vapor growth apparatus 30 according to this embodiment. In FIG. 7, the filled region having a high concentration represents the first source gas 210 at a high concentration; the filled region having a low concentration represents the first source gas 210 at a low concentration; and the filled region having an intermediate concentration represents the first source gas 210 at an intermediate concentration. On the other hand, the hatched dot region having a high density represents the second source gas 220 at a high concentration; the dot region having a low density represents the second source gas 220 at a low concentration; and the dot region having an intermediate density represents the second source gas 220 at an intermediate concentration. Regions in which the concentration of the separation gas 230 is relatively high are represented by lines without hatching. In this example, the first source gas 210 is a group 3 source gas; the second source gas 220 is a group 5 source gas; and the separation gas 230 is hydrogen.

As illustrated in FIG. 7, the concentration of the hatching is high at an aperture portion of the first source gas introduction path 110 at the reaction chamber 150. The first source gas 210 is shown flowing from the first source gas introduction path 110 into the reaction chamber 150.

On the other hand, the concentration of the hatching is low at an aperture portion of the second source gas introduction path 120 at the reaction chamber 150. The second source gas 220 flows from the second source gas introduction path 120 into the reaction chamber 150.

The portions with hatchings of high concentrations and the portions with hatchings of low concentrations recited above do not mix. Restated, the shading of the concentrations of both the first and second source gases 210 and 220 appear distinctly.

Thus, by using the outside pipe 142, which is around the inside pipe 141 forming the first source gas introduction path 110, as the separation gas introduction path 130, the separation gas 230 can be introduced into the reaction chamber 150 to surround the first source gas 210.

The first and second source gases 210 and 220 are thereby inhibited from mutually mixing at a location other than on the substrate 160.

Thereby, the vapor growth apparatus 30 according to this embodiment can provide a vapor growth apparatus using multiple source gases to inhibit reactions outside of the target location, that is, the surface of the substrate 160. Thereby, the consumption efficiency of source materials can be improved, negative effects on apparatus life can be avoided, and the stability of manufacturing conditions can be improved.

Although the first source gas introduction path 110 is the inside pipe 141 of the double pipe structural unit 140 in the vapor growth apparatus 30 of this specific example illustrated in FIG. 4 to FIG. 6, the invention is not limited thereto.

For example, the second gas introduction path 110 may be the inside pipe 141 of the double pipe structural unit 140, and the separation gas introduction path 130 may be the outside pipe 142. Additionally, the first source gas introduction path 110 may be the inside pipe of a first double pipe structural unit; the second source gas introduction path 120 may be the inside pipe of a second double pipe structural unit; and the separation gas introduction path 130 may be the outside pipes of the first and second double pipe structural units.

In other words, at least one of the first and second source gas introduction paths 110 and 120 may be the inside pipe 141 of the double pipe structural unit 140; and the separation gas introduction path 130 may be the outside pipe 142 of the double pipe structural unit 140 in which the first and second source gas introduction paths 110 and 120 form the inside pipe 141.

Thereby, the separation gas 230 can surround at least one of the first source gas 210 and the second source gas 220 while being introduced to form a film.

In the double pipe structural unit 140 of the vapor growth apparatus 30 according to this embodiment, the proportion of the flow path cross-sectional area of the inside pipe 141 and the flow path cross-sectional area of the outside pipe 141 and the lengths thereof may be arbitrarily set, and may be appropriately modified. Further, the proportions of the flow path cross-sectional areas and the lengths of the inside pipe 141 and the outside pipe 142 of the double pipe structural unit 140 and the at least one of the first and second source gas introduction path 110 and 120 that does not form the double pipe structural unit 140 may be arbitrarily set, and may be appropriately modified.

In other words, in the case where at least one of the first and second source gas introduction paths 110 and 120 is the inside pipe 141 of the double pipe structural unit 140 and the separation gas introduction path 130 is the outside pipe 142 of the double pipe structural unit 140 in which the first and second source gas introduction paths 110 and 120 are the inside pipe 141, the cross-sectional areas in a direction perpendicular to the introduction direction and the lengths of the first source gas introduction path 110, the second source gas introduction path 120, and the separation gas introduction path 130 may be set arbitrarily to match the desired film formation conditions, and may be appropriately modified.

### Fourth embodiment

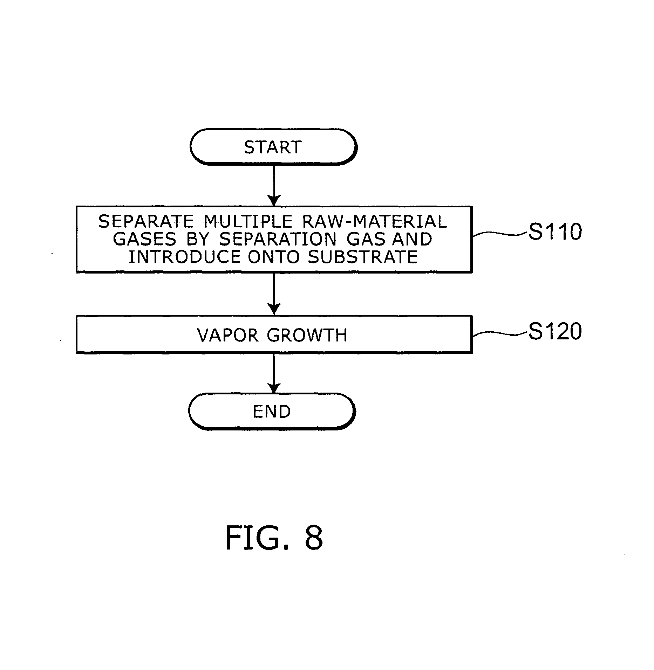

FIG. 8 is a flowchart illustrating a vapor growth method according to a fourth embodiment of the invention.

The vapor growth method according to the fourth embodiment of the invention is a vapor growth method that forms a film on the substrate 160 using multiple source gases, the method introducing the multiple source gases onto the substrate 160 while separating the multiple source gases from each other by the separation gas 230 (step S110). Then, vapor growth is performed (step S120).

That is, the method includes introducing a first source gas and a second source gas onto the substrate while separating the first source gas and the second source gas from each other by a separation gas having a reaction rate with the first source gas lower than a reaction rate between the first source gas and the second source gas and a reaction rate with the second source gas lower than the reaction rate between the first source gas and the second source gas (step S110) and performing vapor growth (step S120).

Step S110 and step S120 recited above may be performed in order, or may be performed simultaneously.

A vapor growth method using multiple source gases can thereby be provided to inhibit reactions outside of the target location, that is, the surface of the substrate 160. Thereby, the consumption efficiency of sources can be improved, negative effects on apparatus life can be avoided, and the stability of manufacturing conditions can be improved.

Any of the vapor growth apparatuses 10, 20, and 30 described in the first to third embodiments may be used when performing the vapor growth method according to this embodiment.

As described in regard to FIG. 1 to FIG. 7, the multiple source gases recited above may include the first source gas 210 and the second source gas 220 which is different from the first source gas 210. The first source gas 210 can be multiply separated by the separation gas 230; the second source gas 220 can be multiply separated by the source gas 230; the second source gas 220 can be introduced between at least two of the multiply separated first source gases 210; and the separation gas 230 can be introduced between each of the first source gases 210 and the second source gas 220.

As described in regard to FIG. 4 to FIG. 7, the separation gas 230 can be introduced to surround at least one of the first source gas 210 and the second source gas 220. In other words, the separation gas 230 can be introduced to surround at least one of the multiple source gases. To this end, the gas introduction paths of a double pipe structure such as that described in regard to FIG. 4 to FIG. 6 may be used.

The first source gas 210 recited above may include a gas including at least one selected from the group consisting of TMG, TMI, TEG, TEA, TEI, a hydride of Si, and a hydrocarbon. These gases may be mixtures including various carrier gases.

The second source gas 220 recited above may include a gas including at least one selected from the group consisting of NH₃, AsH₃, PH₃ and SbH₃. In the vapor growth method according to this embodiment, the first source gas 210 and the second source gas 220 are mutually interchangeable. Also, these gases may be mixtures including various carrier gases.

The first and second source gases 210 and 220 may include various doping gases.

The separation gas 230 recited above may include a gas including at least one selected from the group consisting of N₂, H₂, and a noble gas.

In the vapor growth method according to this embodiment, the substrate 160 may be heated while performing film formation. In particular, the embodiments of the invention can provide marked effects during vapor growth in which the substrate is heated to a high temperature.

The film formation can be performed while introducing the first and second source gases 210 and 220 and the separation gas 230 from the side of the substrate 160. In such a case, for example, the horizontal flow vapor growth apparatus illustrated in FIG. 1 may be used.

Also, the film formation can be performed while introducing the first and second source gases 210 and 220 and the separation gas 230 from above the substrate 160. In such a case, for example, the vertical vapor growth apparatus illustrated in FIG. 3 to FIG. 6 may be used.

### Example

An example will now be described in which the vapor growth apparatus 30 according to the third embodiment recited above is used to implement the vapor growth method according to the fourth embodiment.

Epitaxial growth was performed in the vertical-flow MOCVD apparatus 30 by introducing a gas mixture of trimethyl gallium (TMG) and triethyl aluminum (TEA) with a carrier gas of hydrogen as the first source gas 210, introducing a gas mixture of ammonia (NH₃) with a carrier gas of hydrogen as the second source gas 220, and introducing hydrogen as the source gas 230.

For the first source gas 210 at this time, the concentration of TMG was 93 µmol/min, and the concentration of TMA was 40 µmol/min.

As illustrated in Table 1, film formation was performed at three sets of conditions in which the flow rates of each of the first source gas 210, the second source gas 220, and the separation gas 230 were changed while maintaining the total flow rate of the first source gas 210, the second source gas 220, and the separation gas 230 at a constant 30 slm. The film formation conditions were 100 Torr (133 hPa) at 1,000 °C for 180 seconds.

**[TABLE 1]**

| | FLOW RATE (slm) | | | EPITAXIAL GROWTH FILM | |
|---|---|---|---|---|---|
| | FIRST SOURCE GAS | SECOND SOURCE GAS | SEPARATION GAS | Al MOLE FRACTION | FILM THICKNESS (nm) |
| CONDITION 1 | 5.0 | 10.0 | 15.0 | 0.289 | 60 |
| CONDITION 2 | 7.5 | 12.5 | 10.0 | 0.273 | 58 |
| CONDITION 3 | 10.0 | 15.0 | 5.0 | 0.248 | 52 |

These conditions provided AlGaN epitaxial films having the Al mole fractions and film thicknesses illustrated in Table 1.

As illustrated in Table 1, the film thickness at condition 2 is thicker than that at condition 3; and the film thickness at condition 1 is thicker than that at condition 2. Thus, although the flow rate of the separation gas 230 is higher, the film thickness of the obtained epitaxial film is thick. These results are illustrated in more detail by the AlN growth rate portion and the GaN growth rate portion of the AlGaN epitaxial film illustrated in Table 2 below.

**[TABLE 2]**

| | FLOW RATE (slm) | | | EPITAXIAL GROWTH FILM | |
|---|---|---|---|---|---|
| | FIRST SOURCE GAS | SECOND SOURCE GAS | SEPARATION GAS | AIN GROWTH RATE (nm/s) | GaN GROWTH RATE (nm/s) |
| CONDITION 1 | 5.0 | 10.0 | 15.0 | 0.0963 | 0.237 |
| CONDITION 2 | 7.5 | 12.5 | 10.0 | 0.0880 | 0.234 |
| CONDITION 3 | 10.0 | 15.0 | 5.0 | 0.0716 | 0.217 |

As illustrated in Table 2, increasing the separation gas 230 caused both the AlN growth rate portion and the GaN growth rate portion to increase. This result indicates that increasing the separation gas 230 improved the effective separation of the first source gas 210 and the second source gas 220; improved the efficient separation of the first source gas 210 and the second source gas 220 at locations other than on the substrate 160; and implemented the epitaxial growth more efficiently.

In other words, it was confirmed that the vapor growth apparatus and the vapor growth method according to this embodiment can provide a vapor growth apparatus and a vapor growth method using multiple gases to inhibit reactions outside of the target location, that is, the surface of the substrate 160. Thereby, the consumption efficiency of source materials can be improved, the film formation rate can be improved, negative effects on apparatus life can be avoided, and the stability of manufacturing conditions can be improved.

Although this example illustrates results of the experiments of epitaxial growth of a GaN-type material, similar effects can be obtained by other gas combinations.

The vapor growth apparatus and the vapor growth method according to the embodiments of the invention can manufacture various semiconductor devices.

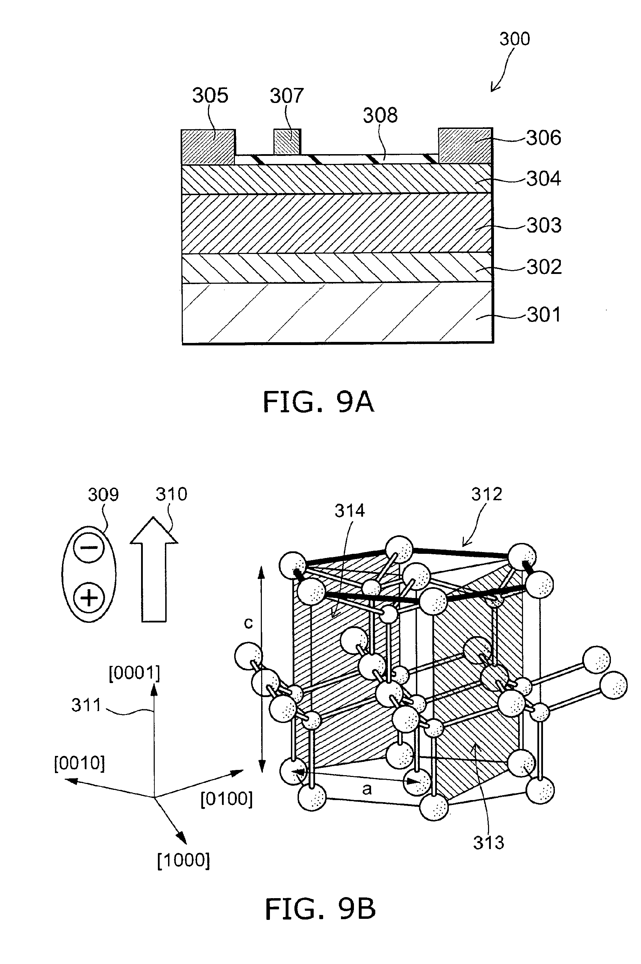

FIGS. 9A and 9B are schematic views illustrating the structure of a semiconductor device manufactured by the vapor growth apparatus and the vapor growth method according to an embodiment of the invention.

Namely, FIGS. 9A and 9B illustrate the structure of a semiconductor device 300 which is a HEMT including an AlGaN/GaN heterointerface. FIG. 9A illustrates a schematic cross-section, and FIG. 9B illustrates the crystalline structure of the semiconductor device 300.

In the HEMT semiconductor device 300 illustrated in FIG. 9A, a buffer layer 302 is provided on a substrate 301. A GaN layer 303 is provided thereupon, and then an AlGaN layer 304 is provided thereupon. A source electrode 305 and a drain electrode 306 are provided on the AlGaN layer. A gate electrode 307 is provided between the source electrode 305 and the drain electrode 306. Although the gate electrode 307 is provided on the AlGaN layer 304 via an insulating film 308 in this specific example, the insulating film 308 may be omitted.

As illustrated in FIG. 9B, the nitride semiconductors of the GaN layer 303 and the AlGaN layer 304 have a hexagonal crystalline structure, including a c-surface 312, an a-surface 313, and an m-surface 314 with crystal axes of [0001], [1000], [0100], and [0010]. Here, the [0001] axis direction perpendicular to the c-surface 312 is a c-axis 311.

Piezoelectric polarization 309 is induced in the interface between the GaN layer 303 and the AlGaN layer 304. An electric field 310 is generated due to the piezoelectric polarization 309. Then, a two-dimensional electron gas is thereby created at the interface between the GaN layer 303 and the AlGaN layer 304. In the case where few impurities are provided in the GaN layer 303, little scattering of impurities occurs during the movement of electrons, and therefore the two-dimensional electron gas has high mobility. Thereby, the semiconductor device 300 of this specific example is characterized by super high frequencies, high-speed characteristics, and low noise.

In this specific example, at least one of the GaN layer 303 and the AlGaN layer 304 is formed by the vapor growth apparatus and/or the vapor growth method according to an embodiment of the invention described above.

Namely, the semiconductor device 300 of this specific example includes: a first layer (for example, the GaN layer 303) which is formed by a first nitride semiconductor (for example, GaN); a second layer (for example, the AlGaN layer 304) provided on the first layer, the second layer being formed by a second nitride semiconductor (for example, an AlGaN layer) having a larger band gap than that of the first nitride semiconductor; a source electrode 305 and a drain electrode 306 provided on the second layer; and a gate electrode 307 provided on the second layer between the source electrode 305 and the drain electrode 306; at least one of the first layer and the second layer being formed by vapor growth by introducing multiple source gases on the substrate while separating the multiple source gases from each other by a separation gas 230.

Thereby, a semiconductor device is obtained which is manufactured by a vapor growth method using multiple gases to inhibit reactions outside of the target location, that is, the surface of the substrate.

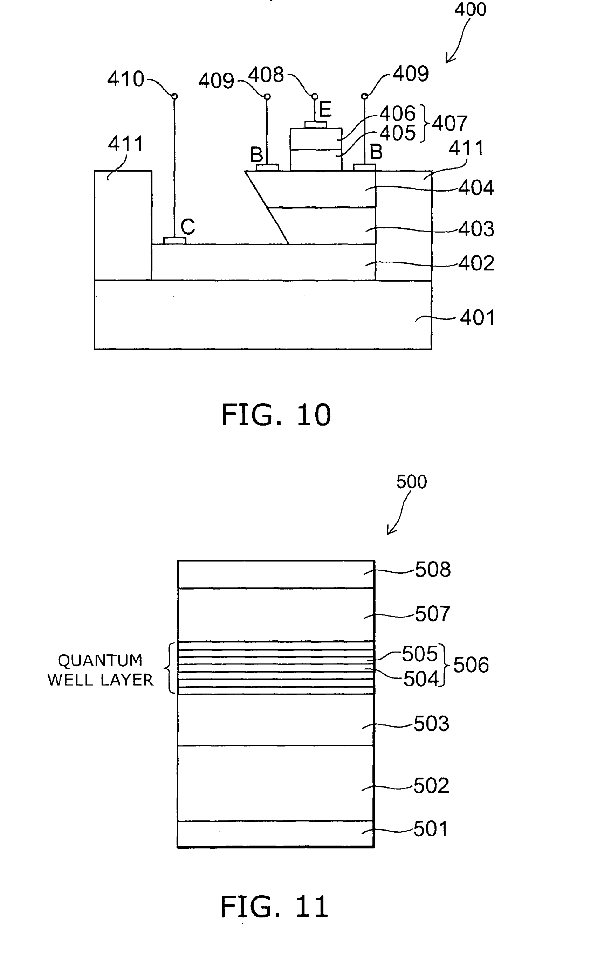

FIG. 10 is a schematic view illustrating the structure of another semiconductor device manufactured by the vapor growth apparatus and the vapor growth method according to an embodiment of the invention.

Namely, FIG. 10 illustrates the structure of a semiconductor device 400 which is a hetero bipolar transistor.

As illustrated in FIG. 10, in the semiconductor device 400, which is a hetero bipolar transistor, for example, an n⁺-type GaAs layer 402 is provided on a major surface of a semi-insulative GaAs substrate 401. A collector layer 403 which is formed by an n-type GaAs layer is provided thereupon. A base layer 404 which is formed by a p-type GaAs layer is provided thereupon. An emitter layer 407 is provided thereupon. The emitter layer 407 includes, for example, an n⁺-type GaAs layer 406 and an n-type AlGaAs layer 405 provided between the n⁺-type GaAs layer 406 and the base layer 404. An emitter electrode 408 connects to the emitter layer 407. A base electrode 409 connects to the base layer 404. A collector electrode 410 connects to the collector layer 403 via the n⁺-type GaAs layer 402. An insulative region 411 is provided on the major surface of the semi-insulative GaAs substrate 401 in a region in which the n⁺-type GaAs layer 402 is not provided.

The collector layer 403, the base layer 404, and the emitter layer 407 recited above form the hetero bipolar transistor. Thus, the semiconductor device 400 illustrated in FIG. 10 is a hetero bipolar transistor having a heterojunction structure with super high-frequency/super-high-speed characteristics.

In this case, at least one of the collector layer 403, the base layer 404, and the emitter layer 407 recited above is formed by the vapor growth apparatus and/or the vapor growth method according to an embodiment of the invention described above.

In other words, the semiconductor device 400 of this specific example includes: a collector layer 403 formed by a semiconductor layer; a base layer 404 provided on the collector layer 403 and formed by a semiconductor layer; an emitter layer 407 provided on the base layer 404 and formed by a semiconductor layer; a collector electrode 410 connected to the collector layer 403; a base electrode 409 connected to the base layer 404; and an emitter electrode 408 connected to the emitter layer 407; the collector layer 403, the base layer 404, and the emitter layer 407 forming a hetero bipolar transistor; and at least one of the collector layer 403, the base layer 404, and the emitter layer 407 being formed by vapor growth by introducing multiple source gases onto the substrate while separating the multiple source gases by the separation gas 230.

Thereby, a semiconductor device is obtained which is manufactured by a vapor growth method using multiple gases to inhibit reactions outside of the target location, that is, the surface of the substrate.

FIG. 11 is a schematic view illustrating the structure of another semiconductor device manufactured by the vapor growth apparatus and the vapor growth method according to an embodiment of the invention.

Namely, FIG. 11 illustrates the structure of a semiconductor device 500 which is an LED (Light Emitting Device).

In the LED semiconductor device 500 illustrated in FIG. 11, for example, an n-type clad layer 503 is provided on one major surface of an n-type substrate 502. A light emitting layer 506 is provided thereupon. A p-type clad layer 507 and then a p-side electrode 508 are provided thereupon. An n-side electrode 501 is provided on the other major surface of the n-type substrate 502.

The light emitting layer 506 is a quantum well layer and may have a structure in which, for example, an n-type AlGaN barrier layer 504 and a GaInN layer 505 are alternately laminated, for example, for three periods.

Although the n-side electrode 501 is provided on a major surface of the n-type substrate 502 opposite to the major surface on which the n-type clad layer 503 is provided in this specific example, the n-side electrode 501 may be provided in another location on the major surface of the n-type substrate 502 on the same side on which the n-type clad layer 503 is provided.

In this specific example, at least one of the n-type clad layer 503, the light emitting layer 506, and the p-type clad layer 507 is formed by the vapor growth apparatus and/or the vapor growth method according to an embodiment of the invention described above.

In other words, the semiconductor device 500 of this specific example includes: a first semiconductor layer (for example, the n-type clad layer 503); a second semiconductor layer (for example, the p-type clad layer 507); the light emitting layer 506 provided between the first semiconductor layer and the second semiconductor layer; a first electrode (for example, the n-side electrode 501) connected to the first semiconductor layer; and a second electrode (for example, the p-side electrode 508) connected to the second semiconductor layer; at least one of the first semiconductor layer, the second semiconductor layer, and the light emitting layer being formed by vapor growth by introducing multiple source gases onto the substrate while separating the multiple source gases from each other by the separation gas 230.

Thereby, a semiconductor device is obtained which is manufactured by a vapor growth method using multiple gases to inhibit reactions outside of the target location, that is, the surface of the substrate.

Thus, the semiconductor device according to an embodiment of the invention includes a semiconductor layer and an electrode connected to the semiconductor layer, the semiconductor layer being formed by vapor growth by introducing multiple source gases onto a substrate while separating the multiple source gases by the separation gas 230.

Thereby, a semiconductor device is obtained which is manufactured by a vapor growth method using multiple gases to inhibit reactions outside of the target location, that is, the surface of the substrate.

Hereinabove, embodiments of the invention are described with reference to specific examples. However, the invention is not limited to these specific examples. For example, one skilled in the art may appropriately select specific configurations of components of the vapor growth apparatus, the vapor growth method, and the method for manufacturing the semiconductor device from known art and similarly practice the invention. Such practice is included in the scope of the invention to the extent that similar effects thereto are obtained.

Further, any two or more components of the specific examples may be combined within the extent of technical feasibility; and are included in the scope of the invention to the extent that the purport of the invention is included.

Moreover, all vapor growth apparatuses, vapor growth methods, and methods for manufacturing the semiconductor device that can be obtained by an appropriate design modification by one skilled in the art based on the vapor growth apparatuses, the vapor growth methods, and the methods for manufacturing the semiconductor device described above as embodiments of the invention also are within the scope of the invention to the extent that the purport of the invention is included.

Furthermore, various modifications and alterations within the spirit of the invention will be readily apparent to those skilled in the art. All such modifications and alterations should therefore be seen as within the scope of the invention.

## Claims

1. A vapor growth apparatus forming a film on a substrate using a first source gas and a second source gas different from the first source gas, the apparatus comprising:
a reaction chamber, the substrate being disposed in the reaction chamber;
a first source gas introduction path communicating with the reaction chamber and introducing the first source gas;
a second source gas introduction path communicating with the reaction chamber and introducing the second source gas; and
a separation gas introduction path communicating with the reaction chamber between the first source gas introduction path and the second source gas introduction path and introducing a separation gas, the separation gas having a reaction rate with the first source gas lower than a reaction rate between the first source gas and the second source gas, and the separation gas having a reaction rate with the second source gas lower than the reaction rate between the first source gas and the second source gas.

2. The apparatus according to claim 1, wherein:
a plurality of the first source gas introduction paths are provided;
a plurality of the second source gas introduction paths are provided;
a plurality of the separation gas introduction paths are provided;
the first source gas introduction paths and the second source gas introduction paths are alternately provided; and
each of the separation gas introduction paths communicate with the reaction chamber between the first source gas introduction path and the second source gas introduction path provided adjacently.

3. The apparatus according to claim 1, wherein:
a plurality of the first source gas introduction paths are provided;
a plurality of the second source gas introduction paths are provided;
at least one of the second source gas introduction paths is provided between at least two of the first source gas introduction paths; and
the separation gas introduction path is provided between each of the first source gas introduction paths and the second source gas introduction path.

4. The apparatus according to claim 1, wherein the separation gas is introduced into the reaction chamber to surround one of the first source gas and the second source gas.

5. The apparatus according to claim 1, wherein
at least one of the first and the second source gas introduction paths is an inside pipe of a double pipe structural unit, and
the separation gas introduction path is an outside pipe of the double pipe structural unit.

6. The apparatus according to claim 1, wherein
the reaction chamber includes a substrate holder upon which the substrate is placed, and
the first source gas introduction path, the second source gas introduction path, and the separation gas introduction path are provided at a side of the substrate holder.

7. The apparatus according to claim 6, wherein the reaction chamber further includes an exhaust portion provided on a side of the substrate holder opposite to the side at which the first source gas introduction path, the second source gas introduction path, and the separation gas introduction path are provided to exhaust gas that has finished reacting.

8. The apparatus according to claim 1, wherein
the reaction chamber includes a substrate holder on which the substrate is placed, and
the first source gas introduction path, the second source gas introduction path, and the separation gas introduction path are provided above the substrate holder.

9. The apparatus according to claim 8, wherein the reaction chamber further includes an exhaust portion provided below the substrate holder to exhaust gas that has finished reacting.

10. The apparatus according to claim 8, wherein the substrate holder includes a heater that heats the substrate.

11. The apparatus according to claim 1, wherein the first source gas and the second source gas are mutually reacting gases.

12. The apparatus according to claim 1, wherein the first source gas includes at least one selected from the group consisting of trimethyl gallium, trimethyl indium, triethyl gallium, triethyl aluminum, triethyl indium, a hydride of Si, and a hydride of carbon.

13. The apparatus according to claim 1, wherein the second source gas includes at least one selected from the group consisting of NH₃, AsH₃, PH₃ and SbH₃.

14. The apparatus according to claim 1, wherein at least one of the first source gas and the second source gas includes a doping gas.

15. The apparatus according to claim 1, wherein the separation gas includes at least one selected from the group consisting of N₂, H₂, helium, neon, argon, krypton, xenon, and radon.

16. The apparatus according to claim 1, wherein the first source gas and the second source gas are introduced onto the substrate in a state of being separated by the separation gas.

17. A vapor growth method forming a film on a substrate using a plurality of source gases,
the method performing vapor growth by introducing a first source gas and a second source gas onto the substrate while separating the first source gas and the second source gas from each other by a separation gas having a reaction rate with the first source gas lower than a reaction rate between the first source gas and the second source gas and a reaction rate with the second source gas lower than the reaction rate between the first source gas and the second source gas.

18. The method according to claim 17, wherein the separation gas is introduced to surround at least one of the first source gas and the second source gas.

19. A method for manufacturing a semiconductor device,
the device including a semiconductor layer vapor-deposited on a substrate and an electrode connected to the semiconductor layer,
the method comprising introducing a first source gas being a source material of the semiconductor layer, and a second source gas being a source material of the semiconductor layer, onto the substrate to perform vapor growth of the semiconductor layer while separating the first and the second source gases from each other by a separation gas having a reaction rate with the first source gas lower than a reaction rate between the first source gas and the second source gas and a reaction rate with the second source gas lower than the reaction rate between the first source gas and the second source gas.

20. The method according to claim 19, wherein the separation gas is introduced to surround at least one of the first and the second source gases.
